# EUROPEAN PATENT APPLICATION

(11) **EP 4 725 843 A1**
(43) Date of publication of application: **15.04.2026**
(21) Application number: 25208311.8
(22) Date of filing: 13.10.2025
(51) Int. Cl.: B64D 27/33, B60L 58/16, B60L 58/18, G01R 31/389, G01R 31/392, B64D 27/357

(54) **AIRCRAFT HYBRID ELECTRIC PROPULSION SYSTEM WITH BATTERY UNIT EVALUATION AND METHOD THEREFOR**

(30) Priority: 11.10.2024 US 202418913898
(71) Applicant: PRATT & WHITNEY CANADA CORP., Longueuil, Québec J4G 1A1 (CA)
(72) Inventor: GARIEPY, Raphael, Longueuil, Québec J4G 1A1 (CA); SHENOUDA, Antwan, Longueuil, Québec J4G 1A1 (CA); MESHKINFAM, Ezzat, Longueuil, Québec J4G 1A1 (CA); HANNA, Michael, Longueuil, Québec J4G 1A1 (CA); KHARAL, Fraz, Longueuil, Québec J4G 1A1 (CA)
(74) Representative: Dehns

(57) **Abstract**

A method of evaluating a battery cell (44) within a battery module (42) of an aircraft hybrid-electric propulsion (HEP) system (20) is provided. The HEP system (20) includes a thermal engine (22), an electric motor (24), and a propulsion unit (28). The HEP system (20) is configured to control at least one of the thermal engine (22) or the electric motor (24) to be in drive communication with propulsion unit (28). The method includes: controlling the HEP system (20) to have the battery module (42) and the battery cell (44) disposed in a rest mode; determining an open-circuit voltage (OCV) of the battery cell (44) after a settling period of time; determining an internal resistance value of the battery cell (44) using the determined OCV; and evaluating the battery cell (44) based on the determined OCV and the determined internal resistance value.

## Description

### BACKGROUND OF THE INVENTION

### 1. Technical Field

The present disclosure relates to aircraft hybrid electric propulsion (HEP) systems in general, and to battery systems used in HEP systems in particular.

### 2. Background Information

Hybrid electric propulsion (HEP) systems utilize a combination of motive power produced by a thermal engine such as a gas turbine engine and motive power from an electric motor to provide propulsion for an aircraft. HEP systems typically utilize a battery system to store electrical energy that can be used to power the electric motor. It would be useful to have an improved battery monitoring system that provides information regarding the state of health of the batteries within the battery system.

### SUMMARY

According to an aspect of the present disclosure, a method of evaluating a battery cell within a battery module of an aircraft hybrid-electric propulsion (HEP) system is provided. The HEP system includes a thermal engine, an electric motor, and a propulsion unit. The HEP system is configured to control at least one of the thermal engine or the electric motor to be in drive communication with propulsion unit. The method includes: controlling the HEP system to have the battery module and the battery cell disposed in a rest mode; determining an open-circuit voltage (OCV) of the battery cell after a settling period of time; determining an internal resistance value of the battery cell using the determined OCV; and evaluating the battery cell based on the determined OCV and the determined internal resistance value.

In any of the aspects or embodiments described above and herein, the battery cell may be one of a plurality of battery cells and the battery module may be one of a plurality of battery modules within a battery string.

In any of the aspects or embodiments described above and herein, in the rest mode, the battery cell may be free of any applied drive load.

In any of the aspects or embodiments described above and herein, the step of evaluating the battery cell may be performed after the settling period of time.

In any of the aspects or embodiments described above and herein, the settling period of time may extend between a first point in time when the battery module is free of a drive load and a second point in time when the battery cell is at a state of substantial ionic equilibrium.

In any of the aspects or embodiments described above and herein, the step of evaluating the battery cell may include comparing the determined OCV of the battery cell to a comparison value based on collected battery cell OCV data.

In any of the aspects or embodiments described above and herein, the battery cell may be a first battery cell of a plurality of battery cells, and the collected battery cell OCV data may be determined from the plurality of battery cells.

In any of the aspects or embodiments described above and herein, the comparison value may be an average OCV of the collected battery cell OCV data, or a statistical measure determined from the collected battery cell OCV data, or a threshold value.

In any of the aspects or embodiments described above and herein, the method may include scheduling maintenance of the battery module based on the evaluation of the battery cell.

In any of the aspects or embodiments described above and herein, the step of evaluating the battery cell may include determining trend data using the determined OCV.

In any of the aspects or embodiments described above and herein, the method may include scheduling maintenance of the battery module based on the determined trend data.

According to an aspect of the present disclosure, an aircraft hybrid-electric propulsion (HEP) system is provided that includes a gearbox, a thermal engine, an electric motor, a battery unit, and a system controller. The thermal engine is in selective drive engagement with the gearbox. The electric motor in selective drive engagement with the gearbox. The HEP system is configured to control at least one of the thermal engine or the electric motor to be in drive communication with the gearbox. The battery unit is configured to provide electrical power to power the electric motor, and the battery unit includes a battery module having a plurality of battery cells. The system controller is in communication with the electric motor, the battery unit, and a non-transitory memory storing instructions. The instructions when executed cause the system controller to: control the HEP system to have the battery module and the battery cell disposed in a rest mode; determine an open-circuit voltage (OCV) of each battery cell of the plurality of battery cells after a settling period of time; determine an internal resistance value of each battery cell of the plurality of battery cells using the determined OCV for the respective battery cell; and evaluate each respective battery cell of the plurality of battery cells based on the determined OCV of the respective battery cell and the determined internal resistance value of the respective battery cell.

In any of the aspects or embodiments described above and herein, the instructions when executed that cause the system controller to evaluate the battery cell may include causing the system controller to compare the determined OCV of each respective battery cell of the plurality of battery cells to a comparison value based on collected battery cell OCV data, and the comparison value may be an average OCV value of the collected battery cell OCV data, or a statistical measure determined from the collected battery cell OCV data, or a threshold value.

In any of the aspects or embodiments described above and herein, the instructions when executed may cause the system to determine trend data for each respective battery cell of the plurality of battery cells using the determined OCV for the respective battery cell.

The foregoing features and elements may be combined in various combinations without exclusivity, unless expressly indicated otherwise. For example, aspects and/or embodiments of the present disclosure may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

FIG. 1 is a diagrammatic representation of an aircraft hybrid-electric propulsion system embodiment.
FIG. 2 is a diagrammatic view of a unit embodiment.
FIG. 3 is a diagrammatic view of a battery module embodiment.
FIG. 4 is a diagrammatic view of a battery module embodiment.
FIG. 5 is a diagram of a battery module embodiment in signal communication with a system controller.

### DETAILED DESCRIPTION

Aspects of the present disclosure system are directed to an aircraft hybrid electric propulsion (HEP) system 20 configured to evaluate the health of battery cells within a battery unit. The HEP system 20 includes a thermal engine 22, an electric motor 24 ("eMotor 24"), a battery unit 26, and a propulsion unit 28. Embodiments of the HEP system 20 may include an electric motor control system 30 ("eMotor control system 30"), a fuel system 32, a fuel control system 34, and a reduction gearbox 36 ("RGB 36"), as well as other components. In some embodiments, the HEP system 20 may include an electric generator 38.

The term "thermal engine 22" as used herein includes various types of gas turbine engines, internal combustion engines (e.g., a piston engine or a rotary engine), and the like that combust traditional aviation fuels and/or sustainable aviation fuels (SAFs), or the like.

The eMotor 24 may be an alternating current (AC) motor configured to rotationally drive at least a portion of the RGB 36, or may be configured to provide rotational drive to a thermal engine 22, or the like.

The propulsion unit 28 is a driven device that is configured to selectively produce thrust that can be used to power an aircraft. The propulsion unit 28 as described herein includes a propeller that has propeller blades. In alternative embodiments, the propulsion unit 28 may include fan blades. The present disclosure is not limited to use with any particular propulsion unit 28 configuration.

The eMotor control system 30 may include hardware and controls for providing electrical power to the eMotor 24. In those embodiments wherein the battery unit 26 provides the electrical power used to power the eMotor 24, the eMotor control system 30 may include an inverter configured to manage electrical power from the battery unit 26. In some embodiments, the inverter may be integral with a system controller (described herein) or in communication with a system controller.

The fuel system may include a fuel reservoir and one or more fuel pumps for pumping the fuel to the thermal engine 22.

The fuel control system may include an electronic controller such as a FADEC or may include a mechanical controller, or any combination thereof. The present disclosure is not limited to any particular type of fuel control system.

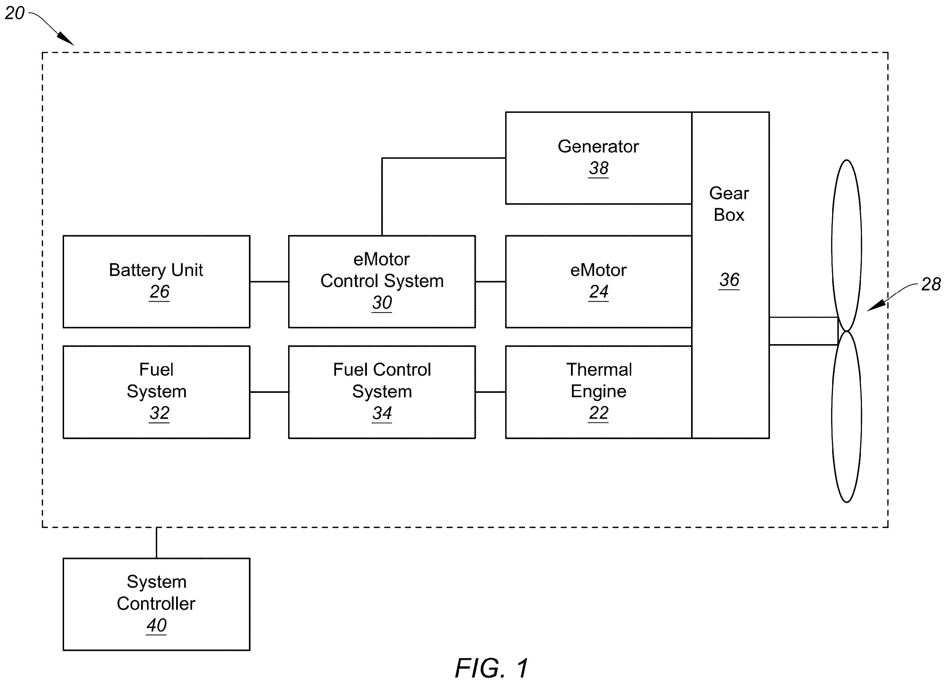

The RBG is configured to accept an input rotational drive at a first rotational drive speed (S1) and at a first torque (T1) and produce an output rotational drive at a second rotational drive speed (S2) and at a second torque (T2). The present disclosure is not limited to any particular type of RBG. In the HEP system 20 embodiment shown in FIG. 1, the RBG may be driven by the thermal engine 22, or by the eMotor 24, or a combination thereof; e.g., in a parallel configuration as diagrammatically shown in FIG. 1. The present disclosure is not limited to the any particular HEP system 20 configuration.

The term "controller" as used herein refers to a device that may include any type of computing device, computational circuit, processor(s), CPU, computer, or the like capable of executing a series of instructions that are stored in memory. The instructions may include an operating system, and/or executable software modules such as program files, system data, buffers, drivers, utilities, and the like. The executable instructions may apply to any functionality described herein to enable the HEP system 20 (or a system component) to accomplish the same algorithmically and/or coordination of system components. A controller may include or may be in communication with one or more memory devices. The present disclosure is not limited to any particular type of memory device, and the memory device may store instructions and/or data in a non-transitory manner. Examples of memory devices that may be used include read-only memory, random access memory, volatile memory, non-volatile memory, static memory, dynamic memory, flash memory, cache memory, and/or any device that stores digital information. A controller may include, or may be in communication with, an input device that enables a user to enter data and/or instructions, and may include, or be in communication with, an output device configured, for example to display information (e.g., a visual display or a printer), or to transfer data, etc. Communications between a controller and other system components may be via a hardwire connection or via a wireless connection.

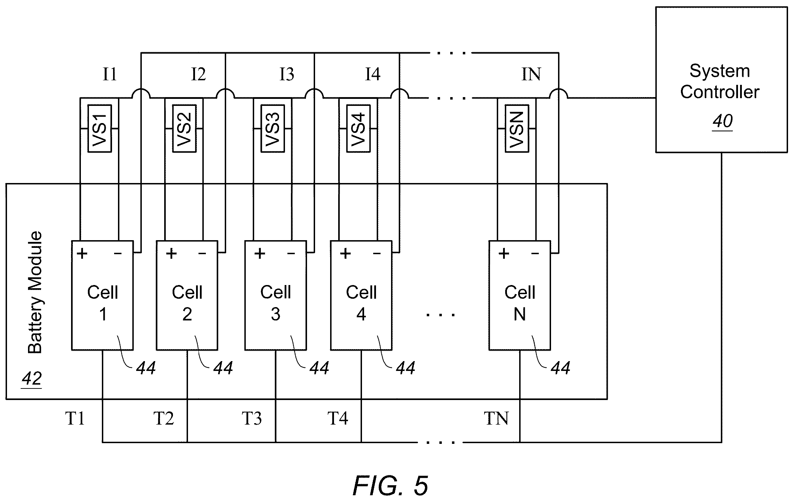

Embodiments of the present disclosure HEP system 20 may include a single system controller 40 configured to control multiple system components, or a plurality of controllers that act in concert, or a plurality of independent controllers. To facilitate the description herein, the present disclosure is described herein in terms of a single system controller 40 (e.g., see FIG. 5). The present disclosure HEP system 20 is not limited to any particular controller architecture. As indicated, the system controller 40 may include one controller or a plurality of controllers.

Implementation of the techniques, blocks, steps, and means described herein may be done in various ways. For example, these techniques, blocks, steps, and means may be implemented in hardware, software, or a combination thereof. For a hardware implementation, processing devices configured to carry out the described functions and steps (e.g., by executing stored instructions) may be implemented within one or more application specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, or other electronic units designed to perform the functions described herein, and/or any combination thereof.

Embodiments of the present disclosure may be described herein as a process which is depicted as a flowchart, a flow diagram, a block diagram, etc. Although any one of these structures may describe the operations as a sequential process, many of the operations can be performed in parallel and/or concurrently. In addition, the order of the operations may be rearranged. A process may correspond to a method, a function, a procedure, a subroutine, a subprogram, etc.

The battery unit 26 is configured to selectively store electrical energy in a first operational mode (i.e., a charging mode), to produce electrical energy in a second operational mode (i.e., a discharging mode), or to neither produce nor store electrical energy in a third operational mode; i.e., a rest mode.

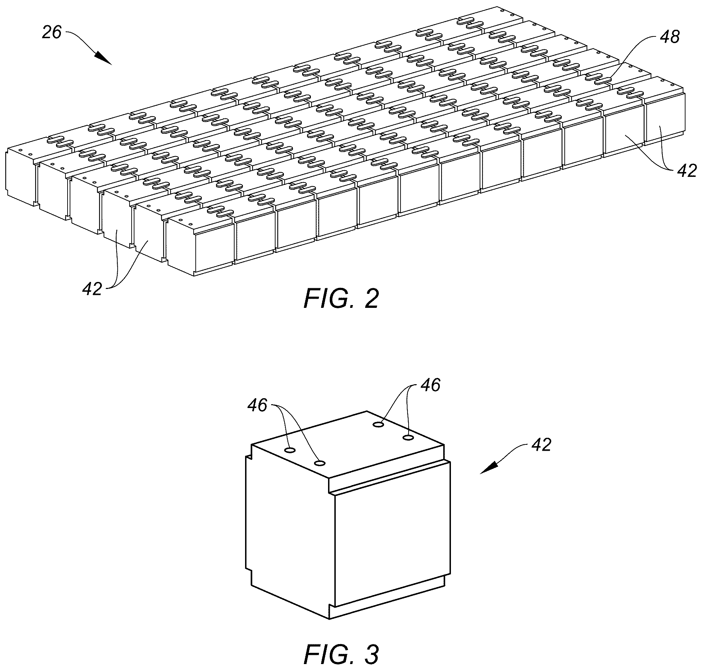

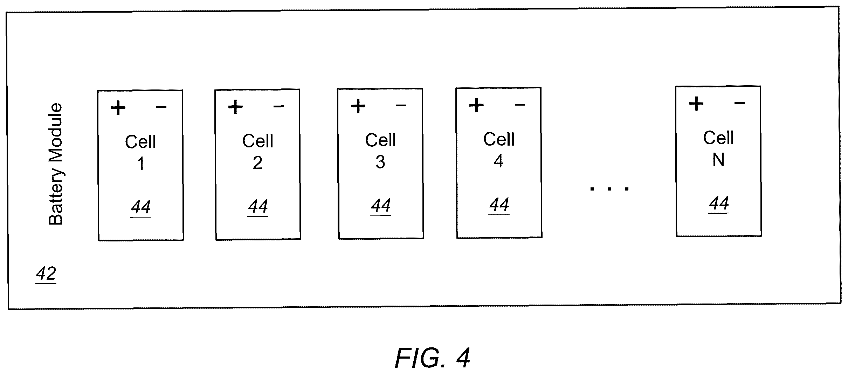

A variety of different battery unit 26 configurations may be used and the present disclosure is not limited to any particular battery unit 26 configuration. A non-limiting example of a battery unit 26 is diagrammatically shown in FIG. 2 in the form of a battery string, sometimes referred to as a battery pack. The battery string includes a plurality of battery modules 42. An individual battery module 42 is shown in FIG. 3. Each battery module 42 includes a housing that contains a plurality of battery cells 44, and the like. FIG. 4 diagrammatically illustrates a battery module 42 having one through "N" (1-N) battery cells 44, where "N" is an integer. Each battery module 42 includes one or more electrical connection ports 46 (see FIG. 3). Electrical connection members 48 (e.g., wires, cables, strips, and the like - see FIG. 2) may be used to electrically connect battery modules 42 within the battery string; e.g., in a series arrangement. Each battery cell 44 includes a positive terminal and a negative terminal and is configured to generate electrical energy from chemical reactions.

Within a battery module 42 and a battery string, the battery cells 44 are typically the same; e.g., each battery cell 44 has the same design, and is intended to have the same electrical properties. However, even amongst the "same" battery cells 44, no two cells 44 are exactly alike due to manufacturing tolerances, material variances, and the like. Moreover during usage, all the battery cells 44 in a battery string are likely not exposed to the exact same environmental factors; e.g., some battery cells 44 may be exposed to different temperatures ranges compared to other battery cells 44, and the like. As a result, during usage it is possible that the performance of some battery cells 44 will vary relative to the performance of other battery cells 44. All battery cells 44 experience performance degradation over time, and some battery cells 44 will degrade at a different rate (i.e., faster or slower) than other battery cells 44.

The present disclosure battery evaluation system produces information regarding the health status of each respective battery cell 44, and that information may be produced during the operation of the HEP system 20. In some embodiments, the health status of a battery cell 44 may be based solely on the open-circuit voltage (OCV) and internal resistance of each battery cell 44. In some embodiments, the health status of a battery cell 44 may be based on additional battery cell information.

The present disclosure system 20 is configured to collect battery cell information, including but not limited to, the OCV and internal resistance of each battery cell 44. The battery cell information may be collected under consistent operating parameters to facilitate data review. An example of consistent operating parameters is while the HEP system 20 is operating but no load is being drawn from the battery unit 26 and the battery unit 26 is not being charged. The consistent operating parameters may also include the collecting the battery cell information after a settling period. The settling period may be chosen based on a period of time extending from the point in time that all loads drawn on the battery unit 26 are terminated to a point in time when the battery cell 44 reaches a state of substantial ionic equilibrium. The term "substantial" as used herein with regard to ionic equilibrium refers to a state wherein ionic transfer within the battery cell 44 has reached equilibrium or a state wherein any ionic transfer is closely approaching equilibrium and any remaining ionic transfer is inconsequential for purposes of determining the OCV of the battery cell 44. The battery unit 26 will be in a rest mode during the settling period and during a sensing period when battery cell information is collected.

Each battery module 42 is configured so that the OCV of each respective battery cell 44 can be measured. For example, each battery cell 44 may be in signal communication with a voltage sensor; e.g., see VS1-VSN in FIG. 5. The voltage sensor, in turn, may provide a signal to the system controller 40 that is indicative of the OCV of the respective battery cell 44. FIG. 5 is a diagram representative of signal lines between battery cells 44 within a battery module 42 and a system controller 40. The present disclosure is not limited to any particular configuration for determining the OCV of a battery cell 44; e.g., the present disclosure does not require a voltage sensor for each battery cell 44. The OCV of each respective battery cell 44 may be collected periodically. The OCV of a battery cell 44 may be evaluated in real-time (e.g., each time the battery cell information is collected), or may be evaluated at predetermined operational stages, or may be evaluated on demand, or any combination thereof. In any of these instances, the collected OCV values may be stored for subsequent use and/or reporting.

The internal resistance of the battery cell 44 may be determined in various different ways. As a non-limiting example, the system may be configured to apply a load to the battery cell 44 (e.g., see the current lines I1-IN within the diagram shown in FIG. 5) and determine the voltage across the battery cell 44 terminals with the load applied. The determined voltage may then be used with the OCV to determine the internal resistance of the battery cell 44. Since the internal resistance of the battery cell 44 will vary as a function of the battery cell temperature, the system may be configured to account for the battery cell temperature when determining the internal resistance of the battery cell 44. It should be noted that battery cell 44 remains in the rest mode when the internal resistance of the battery cell 44 is determined; i.e., the load applied to a battery cell 44 to determine the internal resistance of that battery cell 44 is inconsequential relative to the load (i.e., a "drive load") applied to the battery unit 26 during operation of the battery unit 26 during a discharging mode.

The temperature of a battery cell temperatures may be determined using a temperature sensing device such as a thermistor, an infrared sensor, or the like. A respective temperature sensing device may be disposed with each respective battery cell 44 to provide the temperature of that battery cell 44 to be sensed; e.g., see T1-TN in FIG. 5. The sensed temperature may be communicated to the system controller 40, and may be reported as part of the battery cell 44 health information and/or may be utilized within the present methodology to determine other system information; e.g., battery cell resistance.

The present disclosure system 20 may be configured to evaluate the OCV of a given battery cell 44 in a plurality of different ways, or any combination thereof. As indicated herein, embodiments of the present disclosure system 20 may be configured to periodically collect and store OCV values for battery cells 44. In some embodiments, the OCV of a given battery cell 44 may be evaluated relative to a comparison value determined from the stored OCV values collected from previous sensing periods. In some embodiments, the OCV of a given battery cell 44 may be evaluated relative to comparison value determined from OCV values collected from the same sensing period. Regardless of whether the evaluation is based on data collected from previous sensing periods or the current sensing period, the OCV of a given battery cell 44 may be compared to a comparison value in the form of an average OCV value; e.g., compared to an average OCV value collected from a plurality of battery cells 44 within the battery module 42 and/or battery cells 44 within the battery string. As another example, the OCV of a given battery cell 44 may be compared to a comparison value that is representative of a statistical measure (e.g., a standard deviation) to identify the magnitude of OCV variation of the given battery cell 44 relative to a plurality of other battery cells 44. As yet another example, the OCV of a given battery cell 44 may be compared to a comparison value in the form of a threshold value. The threshold value may be based on collected OCV values, or may be based on an algorithmic approach, or any combination thereof. The present disclosure is not limited to any particular methodology for evaluating the OCV value of a battery cell 44.

The following operational example of the present disclosure system 20 and method is provided to illustrate the utility of the present disclosure. The present disclosure is not limited to this example. During operation of the aircraft powered by the HEP system 20 (or HEP systems), the system controller 40 controls the HEP system 20 so that the battery unit 26 is in a rest mode; i.e., the battery unit 26 is neither in a charging mode nor a discharge mode. The HEP system 20 may be controlled to maintain the battery unit 26 in the rest mode during the settling period and during the period of time when the battery cells 44 are sensed for evaluation purposes; i.e., the sensing period. The battery cell information (e.g., the battery cell OCV and internal resistance) is collected, evaluated, and stored. In some system 20 embodiments, the battery unit 26 rest mode and the battery cell 44 sensing may occur when the aircraft is not operating; e.g., after a flight.

The stored evaluation data (e.g., the battery cell sensed data evaluated relative to average data, statistical data, thresholds, and the like) may be communicated for maintenance purposes. For example, the evaluation data may be used to determine whether a battery cell 44 is performing in an acceptable manner or whether the battery cell 44 is a replacement candidate. The evaluation data may also be used for maintenance projection purposes. For example, embodiments of the present disclosure may track battery cell information (e.g., battery cell OCV and internal resistance) as a function of time and use that battery cell information for trending purposes. In this manner, maintenance requirements not yet necessary may be predicted based on trending; e.g., a battery cell 44 currently operating acceptably but showing incremental degradation perhaps due to aging can be scheduled for maintenance based on trends determined from the battery cell information.

While the principles of the disclosure have been described above in connection with specific apparatuses and methods, it is to be clearly understood that this description is made only by way of example and not as limitation on the scope of the disclosure. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected or the like may include permanent, removable, temporary, partial, full and/or any other possible attachment option.

No element, component, or method step in the present disclosure is intended to be dedicated to the public regardless of whether the element, component, or method step is explicitly recited in the claims. No claim element herein is to be construed under the provisions of 35 U.S.C. 112(f) unless the element is expressly recited using the phrase "means for." As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the disclosures may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the disclosures--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements. It is further noted that various method or process steps for embodiments of the present disclosure are described herein. The description may present method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

## Claims

1. A method of evaluating a battery cell within a battery module of an aircraft hybrid-electric propulsion (HEP) system, the HEP system including a thermal engine, an electric motor, and a propulsion unit, wherein the HEP system is configured to control at least one of the thermal engine or the electric motor to be in drive communication with propulsion unit, the method comprising:
controlling the HEP system to have the battery module and the battery cell disposed in a rest mode;
determining an open-circuit voltage (OCV) of the battery cell after a settling period of time;
determining an internal resistance value of the battery cell using the determined OCV; and
evaluating the battery cell based on the determined OCV and the determined internal resistance value.

2. The method of claim 1, wherein the battery cell is one of a plurality of battery cells and the battery module is one of a plurality of battery modules within a battery string.

3. The method of claim 2, wherein in the rest mode, the battery cell is free of any applied drive load.

4. The method of claim 2 or 3, wherein the step of evaluating the battery cell is performed after the settling period of time.

5. The method of claim 4, wherein the settling period of time extends between a first point in time when the battery module is free of a drive load and a second point in time when the battery cell is at a state of substantial ionic equilibrium.

6. The method of any preceding claim, wherein the step of evaluating the battery cell includes comparing the determined OCV of the battery cell to a comparison value based on collected battery cell OCV data.

7. The method of claim 6, wherein the battery cell is a first battery cell of a plurality of battery cells; and
wherein the collected battery cell OCV data is determined from the plurality of battery cells.

8. The method of claim 7, wherein the comparison value is an average OCV of the collected battery cell OCV data; and/or
wherein the comparison value is a statistical measure determined from the collected battery cell OCV data; and/or
wherein the comparison value is a threshold value.

9. The method of any preceding claim, further comprising scheduling maintenance of the battery module based on the evaluation of the battery cell.

10. The method of any preceding claim, wherein the step of evaluating the battery cell includes determining trend data using the determined OCV.

11. The method of claim 10, further comprising scheduling maintenance of the battery module based on the determined trend data.

12. An aircraft hybrid-electric propulsion (HEP) system, comprising:
a gearbox;
a thermal engine in selective drive engagement with the gearbox;
an electric motor in selective drive engagement with the gearbox;
wherein the HEP system is configured to control at least one of the thermal engine or the electric motor to be in drive communication with the gearbox;
a battery unit configured to provide electrical power to power the electric motor, wherein the battery unit includes a battery module having a plurality of battery cells; and
a system controller in communication with the electric motor, the battery unit, and a non-transitory memory storing instructions, which instructions when executed cause the system controller to:
control the HEP system to have the battery module and the battery cell disposed in a rest mode;
determine an open-circuit voltage (OCV) of each battery cell of the plurality of battery cells after a settling period of time;
determine an internal resistance value of each battery cell of the plurality of battery cells using the determined OCV for the respective battery cell; and
evaluate each respective battery cell of the plurality of battery cells based on the determined OCV of the respective battery cell and the determined internal resistance value of the respective battery cell.

13. The HEP system of claim 12, wherein in the rest mode, each respective battery cell of the plurality of battery cells is free of any applied drive load.

14. The HEP system of claim 13, wherein the instructions when executed cause the system controller to evaluate the battery cell after the settling period of time, and the settling period extends between a first point in time when the battery module is free of a drive load and a second point in time when the battery cell is at a state of substantial ionic equilibrium.

15. The HEP system of claim 14, wherein the instructions when executed that cause the system controller to evaluate the battery cell include causing the system controller to compare the determined OCV of each respective battery cell of the plurality of battery cells to a comparison value based on collected battery cell OCV data, and the comparison value is an average OCV value of the collected battery cell OCV data, or a statistical measure determined from the collected battery cell OCV data, or a threshold value, optionally,
wherein the instructions when executed cause the system to determine trend data for each respective battery cell of the plurality of battery cells using the determined OCV for the respective battery cell.
